# FASCICULE DE BREVET EUROPEEN

(11) **EP 1 417 741 B1**
(45) Date de publication et mention de la délivrance du brevet: **08.10.2008**
(21) Numéro de dépôt: 02755440.1
(22) Date de dépôt: 08.08.2002
(51) Int. Cl.: H02J 7/35, H02N 6/00, H02J 1/00

(54) **PERFECTIONNEMENT POUR CHARGEUR PHOTOVOLTAIQUE**
VERBESSERUNG AN EINEM PHOTOVOLTAISCHEN LADEGERÄT
IMPROVEMENT TO A PHOTOVOLTAIC-TYPE CHARGER

(30) Priorité: 14.08.2001 FR 0111228; 03.05.2002 FR 0205656
(43) Date de publication de la demande: 12.05.2004
(73) Titulaire: Somfy SAS, 74300 Cluses (FR)
(72) Inventeur: BRUNO, Serge, F-74460 Marnaz (FR); NEUMAN, Serge, F-74600 Seynod (FR)
(74) Mandataire: Bugnion Genève
(86) Numéro de dépôt international: PCT/IB2002/003161
(87) Numéro de publication internationale: WO 2003/017446

(56) Documents cités:
- US-A- 4 175 249
- US-A- 5 747 967
- MOCCI F ET AL: "Comparison of power converter technologies in photovoltaic applications" PROCEEDINGS OF MELECON'89. 'INTEGRATING RESEARCH, INDUSTRY AND EDUCATION IN ENERGY AND COMMUNICATION ENGINEERING', - 1989 pages 11-15, XP010083218
- DARRELMANN H: "Alternative Power Storages" PROCEEDINGS OF TELESCON 97, TELECOMMUNICATIONS ENERGY SPECIALIST CONFERENCE, - 24 avril 1997 (1997-04-24) pages 33-40, XP010268192 BUDAPEST, HUNGARY
- GOW J A ET AL: "Controller arrangement for boost converter systems sourced from solar photovoltaic arrays or other maximum power sources" IEE PROCEEDINGS: ELECTRIC POWER APPLICATIONS, INSTITUTION OF ELECTRICAL ENGINEERS, GB, vol. 147, no. 1, 11 janvier 2000 (2000-01-11), pages 15-20, XP006014101 ISSN: 1350-2352

## Description

L'invention concerne un procédé de réalisation d'un panneau photovoltaïque comprenant des cellules photovoltaïques élémentaires et destiné à la charge d'un accumulateur d'énergie électrique basse tension via un convertisseur de tension et un dispositif comportant un accumulateur d'énergie électrique basse tension, un convertisseur élévateur de tension, un panneau photovoltaïque comprenant des cellules photovoltaïques élémentaires et destiné à la charge de l'accumulateur via le convertisseur.

Le domaine du dispositif de charge selon l'invention est celui des accumulateurs basse tension pour lesquels il existe communément des panneaux photo-voltaïques à branchement direct, c'est-à-dire comportant une mise en série interne des cellules (ou photopiles élémentaires) suffisante pour obtenir, sous exposition solaire, une tension à vide du panneau supérieure à la tension de l'accumulateur, et donc permettant directement la charge de l'accumulateur par son raccordement électrique au panneau.

Plus précisément, l'invention concerne des dispositifs du type photo-voltaïque, destinés à satisfaire la charge d'un accumulateur électrique dans des circonstances d'éclairement très variables. En particulier, les dispositifs utilisant un procédé selon l'invention se prêtent à une charge de l'accumulateur lorsque l'éclairement disponible diminue fortement par rapport à sa valeur nominale.

De manière similaire, l'invention s'applique non seulement aux accumulateurs électrochimiques, mais également à la charge d'éléments accumulateurs d'énergie électrique sous forme électrostatique (avec ou sans polarisation), comme les condensateurs ou les super condensateurs.

Il est connu de ne pas utiliser directement la sortie des panneaux photo-voltaïques dans les dispositifs capteurs d'énergie. Le brevet américain US 4,494,180 cite de très nombreuses références scientifiques sur des travaux menés sur la recherche d'un point de fonctionnement optimal. Dans la littérature anglo-saxone, cette démarche est connue sous l'abréviation MPPT : « maximum power point tracking ».

Il s'agit de faire fonctionner le panneau selon des conditions de tension et courant débité qui correspondent au maximum de puissance. Un tel point optimal est représenté par la référence (48) sur la figure 2 du brevet cité. Il est situé au coude de la caractéristique intensité/tension.

Ce brevet décrit notamment comment optimiser la puissance de manière à alimenter directement un moteur, sans même passer par un accumulateur.

On remarquera que dans ce brevet est utilisé un convertisseur DC/DC de rapport N, comme dans la présente invention, mais celui-ci est abaisseur (« buck converter ») et non élévateur. Il s'agit de faire varier la charge apparente vue par le panneau, de manière à rester au coude de courbe caractéristique, intensité/tension du panneau, quel(le) que soit l'éclairement ou la température.

On trouvera d'ailleurs le même souci d'adaptation d'impédance apparente de la charge, vue par le panneau, dans le brevet américain plus ancien US 3,384,806.

Dans le brevet américain US 3,696,286, il s'agit cette fois de piloter au moins un convertisseur à fréquence variable par l'écart entre la tension délivrée par au moins un panneau principal, fonctionnant en charge, et une cellule de référence, fonctionnant à vide tout en étant placée dans les mêmes conditions de température et d'éclairement que le panneau principal.

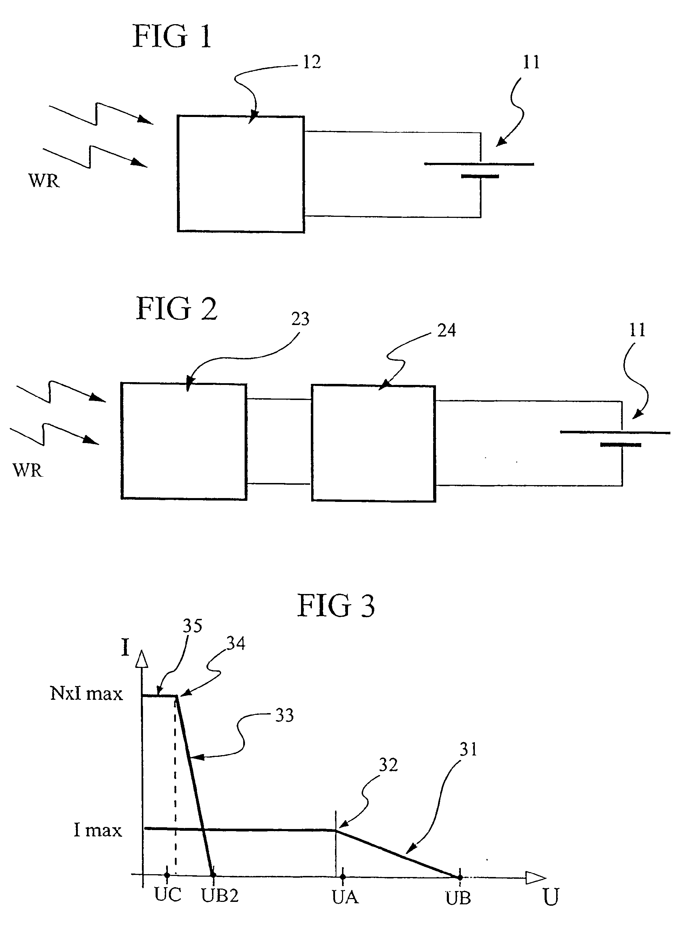

La structure de convertisseur est celle d'un élévateur conventionnel, mais celui-ci joue explicitement le rôle d'amplificateur de puissance, et non de tension, comme représenté en figure 1 et revendiqué. Le but est de diminuer automatiquement la puissance appelée par la charge si la puissance disponible du panneau diminue : il s'agit de nouveau d'un système d'adaptation, de type MPPT.

Ce brevet prévoit d'utiliser plusieurs amplificateurs, chacun fonctionnant à des fréquences variables, pour équilibrer les tensions de sortie de panneaux mis en parallèle.

Le brevet américain US 4,695,785 décrit un dispositif MPPT vis à vis de variations d'éclairement et/ou de température. Le pilotage du dispositif au maximum de puissance disponible est assuré à partir de la mesure périodique (et brève) du courant de court-circuit disponible. Cette valeur est utilisée pour agir sur un régulateur à découpage afin d'adapter la puissance appelée par la charge à la puissance disponible.

Le brevet américain US5,747,967 décrit un dispositif pour la charge d'un accumulateur d'énergie électrique dans des conditions climatologiques variable comprenant, un panneau photovoltaïque comprenant des cellules photovoltaïques élémentaires en série et en parallèle, et un convertisseur élévateur de tension pour charger l'accumulateur depuis le panneau via le convertisseur, qui permet l'optimisation de la puissance générée par le panneau.

Dans les dispositifs connus de l'art antérieur, le but est exclusivement de se rapprocher des conditions de travail au coude de la caractéristique de sortie, courbe intensité/ tension, du panneau, tandis que le dispositif de l'invention est conçu pour exploiter préférentiellement la zone dans laquelle le panneau photo-voltaïque, travaille en générateur de courant c'est-à-dire la partie horizontale de la courbe intensité-tension, quitte à ce que la puissance ne soit pas optimale, le but étant de disposer d'un courant aussi élevé que possible.

L'invention est définie par les caractéristiques techniques du procédé de charge d'un accumulateur d'énergie électrique selon la revendication 1 et du dispositif de charge d'un accumulateur d'énergie électrique selon la revendication 4. D'autres caractéristiques de l'invention sont presentées dans les revendications dépendantes.

Ajoutons que le dispositif de l'invention est avantageusement utilisé, par exemple, pour l'alimentation de moteurs à courant continu pour la manoeuvre temporaire et peu fréquente de protections solaires ou autres, à partir de l'accumulateur. Il s'applique à toute autre utilisation dans laquelle il est souhaité pouvoir aussi bien profiter des situations de faible luminosité ambiante, que des situations d'éclairement direct du panneau, pour permettre la charge de l'accumulateur ou du condensateur.

D'autres caractéristiques et avantages de l'invention se dégageront de la description qui va suivre en regard des dessins annexés (données à titre d'exemples non limitatifs) sans départir du cadre de l'invention tel que défini par les revendications jointes.
La figure 1 est une vue illustrant le dispositif traditionnel.
La figure 2 est une vue schématique du dispositif selon l'invention.
La figure 3 est une représentation graphique de la courbe de charge d'un dispositif traditionnel et du dispositif selon l'invention.
La figure 4 est une vue schématique du dispositif de charge selon l'invention et notamment de son convertisseur élévateur.
La figure 5 illustre le fonctionnement, et visualise les temps de conduction de l'interrupteur du convertisseur.

La figure 1 représente un dispositif de charge traditionnel (12) pour assurer la charge d'un accumulateur (11) de tension nominale (UA), ledit dispositif étant du type à panneau photo-voltaïque, comportant une configuration des cellules élémentaires donnant une tension à vide (UB) supérieure à la tension nominale (UA) de l'accumulateur, et ce pour un éclairement nominal (WR).

Par exemple, si l'accumulateur a une tension nominale de 24 volts, et si la tension à vide d'une cellule élémentaire est de 0.8 volts, le panneau devra contenir au moins 30 groupements de cellules élémentaires, ces groupements étant raccordés en série. A l'intérieur de chaque groupement, les sons connectées en parallèle.

La figure 2 représente un dispositif de charge selon l'invention.

Pour une même surface de panneau, et pour un même accumulateur que précédemment, le procédé selon l'invention consiste à choisir plutôt une configuration des cellules de panneau (23) donnant une tension à vide du panneau (UB2) égale à la tension à vide précédente (UB) divisée par un coefficient multiplicateur (N) pour cette même valeur d'éclairement nominal, et à intercaler entre le panneau et l'accumulateur (11) un élément convertisseur élévateur de tension (24) de facteur multiplicatif égal au coefficient multiplicateur (N), ce dernier (N) étant normalement constant, supérieur à l'unité et aussi grand que possible.

Dans la forme de réalisation préférée d'un dispositif selon l'invention, ce convertisseur (24) possède au moins un mode de fonctionnement par intermittence, associé à un élément de stockage amont de l'énergie électrique.

Un dispositif conventionnel de charge d'un accumulateur de tension nominale (UA) conduit à choisir un panneau tel que la courbe de charge intensité/tension (I/U) présente une tension à vide (UB) supérieure à la tension nominale (UA) de l'accumulateur, comme représenté schématiquement à la figure 3, par la courbe (31).

Pour faciliter la description, on supposera par exemple que cette tension a été obtenue par la mise en série, dans le panneau, de 4 groupements de cellules photo-voltaïques élémentaires.

A l'optimum, comme dans tous les dispositifs "MPPT" (maximum power point tracking), le point de fonctionnement est choisi, dans l'art antérieur, tel que la tension nominale (UA) de l'accumulateur, correspond au coude (32) de la courbe (31).

En rupture avec les pratiques courantes, l'invention préconise, pour une même surface de panneau photo-voltaïque, de favoriser la valeur de l'intensité maximale (I max) du courant de court-circuit, au détriment de la nouvelle tension à vide du panneau (UB2). Par rapport à un dimensionnement normal, l'ancienne tension à vide (UB) sera divisée par le coefficient multiplicateur (N), (UB2 = UB / N), alors que la valeur de l'intensité du courant sera multipliée par le même facteur. On obtient alors la courbe (33).

Dans l'exemple, les quatre groupements de cellules du panneau sont maintenant disposés en parallèle : la tension de sortie du panneau est quatre fois plus faible, donc inférieure à la tension nominale de l'accumulateur, mais le courant maximum que peut fournir le panneau est devenu quatre fois plus important.

L'invention ne recherche pas spécifiquement à suivre le point (34) de maximum de puissance, mais utilisera préférentiellement la plage (35) dans laquelle le panneau se comporte en générateur de courant.

On remarquera que, pour des valeurs importantes du coefficient multiplicateur (N), la caractéristique (33) tend d'ailleurs à devenir rectangulaire, et q'il n'est pas possible de rester, de manière stable, ailleurs que sur la plage (35). Les tensions de coude et à vide ont alors sensiblement la même valeur.

Bien entendu, ce dimensionnement de panneau impose d'intercaler un dispositif élévateur de tension de manière à permettre la charge de l'accumulateur. Pour simplifier, on prendra comme facteur multiplicatif la même valeur (N) que précédemment, mais on pourrait prendre tout aussi bien une valeur différente (M), pourvu que la tension à vide multipliée par le coefficient multiplicateur (N) ou par le coefficient de valeur différente (M) soit supérieure à la tension nominale (UA) de l'accumulateur.

Ce dimensionnement de panneau photo-voltaïque, peut paraître très surprenant, puisqu'il conduit à rendre nécessaire un convertisseur élévateur dont on pourrait très bien se passer par un dimensionnement normal. Cependant, son intérêt réside dans la capacité du panneau à fournir du courant même dans des circonstances de faible éclairement, ce courant étant exploité, dans une dynamique de variation beaucoup plus importante (ici environ N fois plus importante qu'en comparaison de l'art antérieur).

En pratique, le coefficient multiplicateur (N) peut prendre une valeur (non nécessairement entière) aussi grande que possible. Il existe cependant une limitation technologique : il est impératif que la tension à vide du panneau (UB) divisée par le coefficient multiplicateur (N) reste supérieure à la tension d'entrée minimum (UC) permettant le fonctionnement d'un convertisseur élévateur à semi-conducteurs ou autres.

En d'autres termes, l'invention privilégie la mise en parallèle des cellules élémentaires d'un panneau de surface (S) donnée.

Idéalement, la conception selon l'invention revient à utiliser un panneau photovoltaïque ne comportant que des cellules en parallèle pour une surface totale donnée. Il convient alors que la technologie de réalisation du convertisseur présente une tension minimum de fonctionnement, (UC) inférieure à la tension de coude ou au moins à la tension à vide d'une cellule élémentaire du panneau photo-voltaïque.

Tant que ces caractéristiques idéales ne sont pas atteintes, le dimensionnement du panneau selon l'invention devra simplement limiter le nombre de connexions en série de groupements de cellules, à ce qui est nécessaire à l'obtention d'une tension de coude du panneau, ou au moins de tension à vide (UB2), qui soit supérieure au seuil de fonctionnement (UC) du convertisseur.

Dans l'état actuel des technologies de convertisseur, ce seuil de fonctionnement est de l'ordre de 1 volt.

Pour une tension de coude des cellules élémentaires égale à 0.5 volts, on prendra par exemple un panneau dont la surface est divisée en trois groupements en série, en intercalant un tel convertisseur élévateur pris avec un coefficient multiplicateur de 10 pour appliquer l'invention à la charge d'un accumulateur 12 volt. Selon l'art antérieur, la surface de panneau aurait été divisée en au moins 24 groupes connectés en série.

Si on suppose qu'un progrès sur la technologie photovoltaïque donne une tension de coude égale à 1.5 volts pour une cellule élémentaire photovoltaïque, alors l'application du procédé selon l'invention pour la charge d'un accumulateur 12 volt consistera à utiliser des cellules élémentaires en parallèle sur toute la surface du panneau, alors que l'art antérieur aurait réparti cette surface en neuf ou dix groupes connectés en série.

Sur le plan du principe, s'il existe sur la surface S du panneau un nombre total de cellules égal à T, et que la tension de seuil du convertisseur impose la mise en série de P cellules pour obtenir une tension à vide au moins supérieure à la tension de seuil, et qu'on a T = P.Q avec Q entier, alors il est équivalent de réaliser : soit P groupements de Q cellules en parallèle, ces P groupements étant connectés en série, soit Q fois la mise en parallèle de P cellules en série. L'invention s'applique indifféremment à l'un et l'autre cas. Des raisons technologiques, notamment d'équilibrage des courants et/ou tensions dans les différentes cellules ou groupements, font en fait choisir l'une ou l'autre option. L'important est que P, selon l'invention, sera pris aussi petit que possible de manière à maximiser Q.

Les principes précédents sont conservés dans le cas où il est nécessaire de charger un condensateur plutôt qu'un accumulateur électrochimique. La tension (UA) précédemment définie comme étant la tension nominale de l'accumulateur sera cette fois définie soit comme tension d'arrêt de charge du condensateur, soit comme valeur moyenne d'une tension de charge dans un fonctionnement tolérant une faible excursion de part et d'autre de cette valeur.

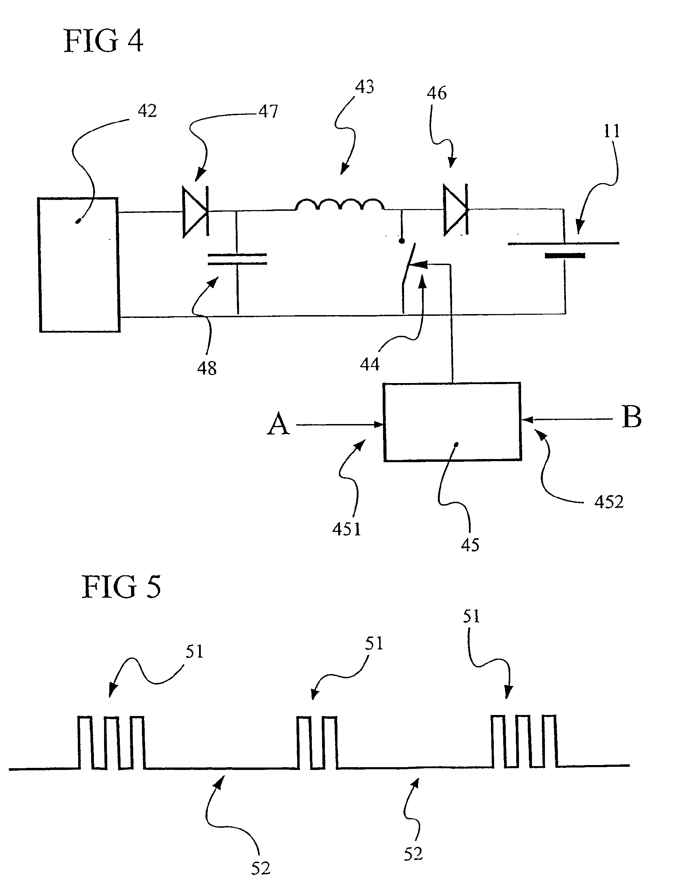

La figure 4 illustre de façon schématique un dispositif dans lequel le panneau (42) est dimensionné selon le procédé de l'invention pour la charge d'un accumulateur (11). D'autres dispositifs non représentés peuvent venir se brancher en parallèle sur cet accumulateur.

Le convertisseur élévateur (24) comprend ici une inductance (43), un interrupteur (44) piloté par un oscillateur (45) dont le rapport cyclique définit l'élévation en tension, et fonctionnant par exemple à fréquence constante, et enfin une diode (46) reliée à l'accumulateur. Toute autre structure élévatrice connue de l'homme de métier conviendrait de même.

Un tel montage permet par exemple la charge d'un accumulateur de 6 volts à partir d'un panneau qui sera choisi pour délivrer une tension de 2.8 volts à vide. Le rapport cyclique est alors choisi à 0.8, ce qui donne un facteur multiplicatif normal du convertisseur égal à 5. On constate que toutes les conditions selon l'invention sont réunies, avec une certaine marge de sécurité.

Ce montage comporte également une diode supplémentaire (47) et un condensateur (48), qui permet de réaliser un élément de stockage amont. Par ailleurs, l'oscillateur (45) est muni d'une entrée (451) inhibant le fonctionnement du convertisseur (24) si la tension sur cette entrée devient inférieure à une tension seuil donnée (U1), et le maintient alors inhibé tant que cette tension n'a pas repris une valeur au moins égale à (U2), supérieure à (U1). La valeur (U1) est prise égale ou légèrement supérieure à la tension de seuil de fonctionnement (UC) du convertisseur.

Dans une première version simplifiée, la diode (47) pourrait être remplacée par un fil conducteur, et le condensateur (48) pourrait être supprimé. On peut également conserver l'un sans l'autre.

Il faut noter que certains circuits, utilisés dans des conditions de faible tension d'alimentation, présentent spontanément ce comportement à double seuil. Ainsi le circuit LT1613 de Linear, qui réalise l'ensemble de la fonction élévateur et oscillateur, cesse-t-il naturellement de fonctionner si sa tension devient inférieure à 0.99 volts environ, et reprend pour une tensions égale à 1.1 volts environ.

Le montage avec diode et condensateur d'entrée est connu de l'homme de l'art, ce montage évitant de solliciter directement le panneau lors de la mise en conduction de l'interrupteur.

Il prend cependant ici une autre fonction, en association avec l'entrée (451), ou le fonctionnement intrinsèque équivalent à cette entrée, celle d'un fonctionnement de type relaxation.

La figure 5 illustre un tel fonctionnement, en visualisant les temps de conduction de l'interrupteur.

Dans les conditions de faible éclairement, il s'agit d'un fonctionnement par « bouffées », délivrant quelques impulsions lorsque le faible courant délivré par le panneau a pu charger suffisamment le condensateur pour atteindre la tension de seuil (U2), ce qui provoque aussitôt le fonctionnement du convertisseur, et donc la décharge du condensateur de stockage amont, jusqu'à atteindre (U1). Le convertisseur cesse alors de fonctionner jusqu'à ce que le condensateur de stockage amont ait pu se recharger sous une tension (U2).

Dans certains cas de faible courant de charge, issu du panneau, on ne dispose ainsi que de quelques impulsions (51), et à la limite un seul cycle de commutation de l'interrupteur. Ces groupes d'impulsions sont séparés par un temps de repos (52) qui diminue quand le courant fourni par le panneau augmente. Dès que le courant débité devient suffisant, la conduction devisent continue, c'est à dire que l'interrupteur fonctionne en permanence avec la fréquence et le rapport cyclique fixés et que le courant de charge de l'accumulateur (ou de tout dispositif placé en parallèle sur l'accumulateur) ne s'interrompt plus.

Cette configuration permet de ne rien perdre des charges électriques fournies par le panneau photo-voltaïque.

Dans la réalisation préférée, la diode (47) n'est pas utilisée, de manière à éviter une chute de tension supplémentaire.

Enfin, il peut être fait également usage d'une entrée d'inhibition (452) dans le cas où la tension de sortie viendrait à dépasser la tension maximum de l'accumulateur à pleine charge.

Dans le cas où c'est un condensateur (ou supercondensateur) (11) qui est avec le dispositif selon l'invention, on remarquera qu'on bénéficie d'un fonctionnement transparent du convertisseur élévateur tant que, une phase initiale de fonctionnement, le condensateur n'a pas atteint une tension au moins égale à la tension de seuil du convertisseur. En effet, la quasi-totalité du courant délivré par le panneau passe à travers l'inductance (43) et la diode (46) pour charger le condensateur (11), dont la capacité est normalement très grande devant celle du condensateur amont (48).

Le rapport cyclique du convertisseur peut être choisi variable de manière à optimiser le temps de conduction de l'interrupteur (44) dans la phase suivante de croissance régulière de la tension aux bornes du condensateur (11) pendant sa charge. L'entrée d'inhibition (452) est utilisée pour mettre fin à la charge au-delà d'une valeur donnée de tension.

## Revendications

1. Procédé de charge d'un accumulateur d'énergie électrique (11) dans des circonstances d'éclairement très variables, comprenant les étapes suivantes :
- on intercale un convertisseur élévateur de tension (24) entre un panneau photovoltaïque et l'accumulateur d'énergie électrique,
- on branche entre les deux bornes du panneau photovoltaïque (23) un nombre minimum de cellules élémentaires en série, ce nombre minimum étant défini de manière à ce que, sous un éclairement donné, la tension de coude du panneau photovoltaïque soit supérieure à la tension (UC) seuil de fonctionnement du convertisseur (24),
- on charge l'accumulateur d'énergie électrique (11) basse tension via le convertisseur élévateur de tension (24), permettant l'utilisation du panneau dans la plage dans laquelle il se comporte en générateur de courant, délivrant, sous un éclairement donné, une intensité de court-circuit aussi élevée que possible.

2. Procédé de charge selon la revendication 1, **caractérisé en ce que** le nombre minimum de cellules élémentaires branchées en série est défini de manière à ce que, sous un éclairement donné, la tension à vide (UB2) du panneau photovoltaïque soit supérieure à la tension (UC) seuil de fonctionnement du convertisseur (24).

3. Procédé de charge selon la revendication 1 ou 2, **caractérisé en ce que** le convertisseur élévateur a un facteur multiplicatif constant.

4. Dispositif de charge d'un accumulateur (11) d'énergie électrique basse tension dans des circonstances d'éclairement très variables comprenant, un panneau photovoltaïque (23) comprenant des cellules photovoltaïques élémentaires en série et en parallèle, et un convertisseur (24) élévateur de tension pour charger l'accumulateur depuis le panneau via le convertisseur, dans lequel la connexion en série des cellules élémentaires dudit panneau est limitée au nombre minimum de cellules nécessaire à l'obtention d'une tension de coude du panneau ou d'une tension à vide (UB2) du panneau qui soit supérieure à la tension seuil de fonctionnement (UC) du convertisseur (24) et permet l'utilisation du panneau dans la plage dans laquelle il se comporte en générateur de courant, avec une intensité de court-circuit aussi élevée que possible.

5. Dispositif selon la revendication 4, **caractérisé en ce que** le convertisseur élévateur a un facteur multiplicatif constant.

6. Dispositif selon la revendication 4 ou 5, **caractérisé en ce que** la valeur de la tension de coude du panneau ou de la tension à vide (UB2) du panneau est de l'ordre de 1 volt.

7. Dispositif selon l'une des revendications 4 à 6, **caractérisé en ce que** toutes les cellules élémentaires du panneau sont connectées en parallèle.

8. Dispositif selon l'une des revendications 4 à 6, **caractérisé en ce que** le convertisseur élévateur utilise une fréquence et/ou un rapport cyclique constants.

9. Dispositif selon l'une quelconque des revendications 4 à 8, **caractérisé en ce que** le convertisseur présente des périodes actives de fonctionnement et des périodes inactives, lesquelles périodes inactives sont mises à profit pour charger à l'aide du panneau, un condensateur de stockage (48) disposé en amont du convertisseur.

10. Dispositif selon la revendication 9, **caractérisé en ce que** le convertisseur (24) comprend un oscillateur (45) muni d'une entrée (451) inhibant le fonctionnement du convertisseur (24) si la tension sur cette entrée devient inférieure à une tension seuil donnée (U1), et le maintient alors inhibé tant que cette tension n'a pas repris une valeur au moins égale à (U2), supérieure à (U1).

11. Dispositif selon l'une quelconque des revendications 4 à 10, **caractérisé en ce que** l'accumulateur d'énergie électrique est de type électrochimique.

12. Dispositif selon l'une quelconque des revendications 4 à 10, **caractérisé en ce que** l'accumulateur d'énergie électrique est de type condensateur ou supercondensateur.

## Claims

1. A method for charging an electrical energy accumulator (11) in very different illumination circumstances, comprising the following steps:
- inserting a step-up voltage converter (24) between a photovoltaic panel and the electrical energy accumulator,
- connecting a minimum number of elementary cells in series between the two terminals of the photovoltaic panel (23), this minimum number being defined in such a way that, under a given illumination, the knee voltage of the photovoltaic panel is greater than the threshold voltage (UC) of operation of the converter (24).
- charging the low voltage electrical energy accumulator (11) via the step-up voltage converter (24), permitting the use of the panel in the range in which it behaves as a current generator, delivering, under a given illumination, a short-circuit intensity that is as high as possible.

2. The charging method according to claim 1, **characterized in that** the minimum number of elementary cells connected in series is defined in a way that, under a given illumination, the no-load tension (UB2) of the photovoltaic panel is higher than the threshold voltage (UC) of operation of the converter (24).

3. The charging method according to claim 1 or 2, **characterized in that** the step-up converter has a constant step-up ratio.

4. A device for charging a low tension electrical energy accumulator (11) in very different illumination circumstances, comprising a photovoltaic panel (23) comprising elementary photovoltaic cells in series and in parallel and a step-up voltage converter (24) for charging the accumulator from the panel via the converter, in which the connection in series of the elementary cells of said panel is limited to the minimum number of cells necessary to obtain a knee voltage of the panel or a no-load tension (UB2) of the panel that is higher than the threshold voltage of operation (UC) of the converter (24) and allows the use of the panel in the range in which it behaves as a current generator, with a short-circuit intensity as high as possible.

5. The device according to claim 4, **characterized in that** the step-up converter has a constant step-up ratio.

6. The device according to claim 4 or 5, **characterized in that** the value of the knee voltage of the panel or of the no-load voltage (UB2) of the panel is about 1 volt.

7. The device according to one of the claims 4 to 6, **characterized in that** all the elementary cells of the panel are connected in parallel.

8. The device according to one of the claims 4 to 6, **characterized in that** the step-up converter uses a constant frequency and/or a constant duty ratio.

9. The device according to anyone of the claims 4 to 8, **characterized in that** the converter has active operation periods and inactive operation periods, which inactive periods are used to charge, with help of the panel, a storage capacitor (48) arranged upstream of the converter.

10. The device according to claim 9, **characterized in that** the converter (24) comprises an oscillator (45) having an entry (451) disabling the operation of the converter (24) when the voltage at this entry becomes lower than a given threshold voltage (U1), and then maintains it disabled so long as this voltage does not reach again a value at least equal to (U2), higher than (U1).

11. The device according to anyone of the claims 4 to 10, **characterized in that** the electrical energy accumulator is of the electrochemical type.

12. The device according to anyone of the claims 4 to 10, **characterized in that** the electrical energy accumulator is of the capacitor or supercapacitor type.

## Patentansprüche

1. Verfahren zum Aufladen eines elektrischen Akkus (11) unter sehr variablen Helligkeitsverhältnissen, mit folgenden Schritten:
- Man schaltet einen die Spannung erhöhenden Wandler (24) zwischen ein Photovoltaik-Panel und den elektrischen Akku,
- man schaltet eine minimale Anzahl von Elementarzellen in Reihe zwischen die beiden Klemmen des Photovoltaik-Panels (23), wobei diese minimale Anzahl so definiert wird, dass bei einer gegebenen Helligkeit die Knickspannung des Photovoltaik-Panels höher ist als die Betriebsschwellenspannung (UC) des Wandlers (24),
- man lädt den elektrischen Niederspannungsakku (11) über den erwähnten Spannungswandler (24), was die Verwendung des Panels in dem Bereich erlaubt, in dem es sich wie ein Stromgenerator verhält, der bei einer gegebenen Helligkeit eine Kurzschlussstärke liefert, die so hoch wie möglich ist.

2. Verfahren nach Anspruch 1, **dadurch gekennzeichnet, dass** die minimale Anzahl von Elementarzellen, die in Reihe geschaltet sind, so definiert wird, dass bei einer gegebenen Helligkeit die Leerlaufspannung (UB2) des Photovoltaik-Panels höher ist als die Betriebsschwellenspannung (UC) des Wandlers (24).

3. Verfahren nach Anspruch 1 oder 2, **dadurch gekennzeichnet, dass** der die Spannung erhöhende Wandler einen konstanten Multiplikationsfaktor hat.

4. Ladevorrichtung zum Aufladen eines elektrischen Niederspannungsakkus (11) unter sehr variablen Helligkeitsverhältnissen, mit einem Photovoltaik-Pannel (23), das in Reihe und parallel geschaltete elementaren Photovoltaik-Zellen aufweist, und mit einem die Spannung erhöhenden Wandler (24), um den Akku vom Panel aus über den Wandler aufzuladen, wobei die Serienschaltung der elementaren Zellen des erwähnten Panels auf die minimale Anzahl von Zellen begrenzt ist, die notwendig ist, um eine Knickspannung des Panels oder eine Leerlaufspannung (UB2) des Panels zu erhalten, die grösser ist als die Betriebsschwellenspannung (UC) des Wandlers (24), und welche die Verwendung des Panels in dem Bereich erlaubt, in welchem es sich wie ein Stromgenerator mit einer Kurzschlussstärke verhält, die so hoch wie möglich ist.

5. Vorrichtung nach Anspruch 4, **dadurch gekennzeichnet, dass** der die Spannung erhöhende Wandler einen konstanten Multiplikationsfaktor hat.

6. Vorrichtung nach Anspruch 4 oder 5, **dadurch gekennzeichnet, dass** die Knickspannung des Panels oder die Leerlaufspannung (UB2) des Panels grösssenordnungsmässig 1 Volt betragt.

7. Vorrichtung nach einem der Ansprüche 4 bis 6, **dadurch gekennzeichnet, dass** alle Elementarzellen des Panels parallel geschaltet sind.

8. Vorrichtung nach einem der Ansprüche 4 bis 6, **dadurch gekennzeichnet, dass** der die Spannung erhöhende Wandler eine konstante zyklische Frequenz und/oder ein konstantes zyklisches Verhältnis verwendet.

9. Verfahren nach einem der Ansprüche 4 bis 8, **dadurch gekennzeichnet, dass** der Wandler aktive Betriebsperioden und inaktive Perioden aufweist und diese inaktiven Perioden dazu ausgenutzt werden, um mit Hilfe des Panels aufzuladen, wobei vor dem Wandler ein Speicherkondensator (48) angeordnet ist.

10. Vorrichtung nach Anspruch 9, **dadurch gekennzeichnet, dass** der Wandler (24) einen Oszillator (45) mit einem Eingang (451) aufweist, welcher den Betrieb des Wandlers (24) verhindert, wenn die Spannung an diesem Eingang unter eine gegebene Schwellenspannung (U1) abfällt, und diese Verhinderung so lange aufrechterhält, bis diese Spannung wieder einen Wert wenigstens gleich (U2), grösser als (U1), erreicht hat.

11. Vorrichtung nach einem der Ansprüche 4 bis 10, **dadurch gekennzeichnet, dass** der elektrische Akku ein elektrochemischer Akku ist.

12. Vorrichtung nach einem der Ansprüche 4 bis 10, **dadurch gekennzeichnet, dass** der elektrische Akku ein Kondensator oder ein Superkondensator ist.
